# EUROPEAN PATENT APPLICATION

(11) **EP 2 413 446 A2**
(43) Date of publication of application: **01.02.2012**
(21) Application number: 11175588.0
(22) Date of filing: 27.07.2011
(51) Int. Cl.: H02G 3/16, F24J 2/52, H01L 31/048, H01R 13/52

(54) **Electric connection system applied in solar curtain wall, frame with such electric connection system, and method for using such electric connection system**

(30) Priority: 27.07.2010 CN 201010244523
(71) Applicant: Tyco Electronics (Shanghai) Ltd, Shanghai 200233 (CN); Tyco Electronics Holdings (Bermuda), Pembroke (BM)
(72) Inventor: Hu, Lintao, 200233 Waigaoqiao Free Trade Zone Shanghai (CN); Chen, Xiaoqun, 200233 Waigaoqiao Free Trade Zone Shanghai (CN); Zhou, Chunfu, Changning District Shanghai (CN); Ko, Henry, Pembroke BM (BM)
(74) Representative: Grünecker, Kinkeldey, Stockmair & Schwanhäusser

(57) **Abstract**

The present invention relates to a field of electric connector, and in particular, to an electric connection system applied in solar curtain wall, a frame with such electric connection system, and a method for using such electric connection system. The present invention discloses an electric connection system applied in solar curtain wall for electric connection among adjacent BIPV glasses in the solar curtain wall including BIPV glasses and frames. The electric connection system at least comprises: a first electric connector connected to an electrically connecting component disposed in the BIPV glass; a second electric connector provided in the frame and adapted for mating with the first electric connector; and a third electric connector through which the second electric connectors in the adjacent frames are electrically connected with each other. Also, the present invention discloses a method for using such electric connection system. Further, the present invention discloses a frame with such electric connection function, which is applied on BIPV glasses.

## Description

### BACKGROUND OF THE INVENTION

### Field of the Invention

The present invention relates to an electric connector, and in particular, to an electric connection system applied in solar curtain wall, a frame with such electric connection system, and a method for using such electric connection system.

### Description of the Related Art

It is well-known that solar energy is one kind of popular regenerative energies. Much more attentions are paid on the conversion of solar energy into electric energy since it both releases the electricity shortage and decreases environmental pollutions. Building Integrated Photovoltaic (BIPV) technology, a new solar energy utilizing technology is appeared recently. The BIPV technology aims to integrate the solar (photovoltaic) electrical generation products into some parts of the buildings, e.g., lighting roof, windows, and solar glass curtain wall, etc.. These integrated solar (photovoltaic) electrical generation products function both rains and winds shielding and lighting-taking. Taken the solar curtain wall as an example, electric connections between adjacent glasses are achieved by the junction boxes in the conventional Building Integrated Photovoltaic (BIPV) technology. Presently, the junction boxes for electric connections usually are directly adhered to the glasses of the solar curtain wall or are adhered to the periphery of the glasses. However, such installations of the junction boxes may have the following disadvantages. First of all, the junction boxes are directly exposed to the outside since the junction boxes usually are provided outside the solar curtain wall and the solar curtain wall frame. Thus, the junction boxes may be easily damaged, e.g., by the execrable outdoor environmental factors, such as windstorm and rainstorm, to cause the destruction of the whole photovoltaic system. What's more, in view of a whole appearance of the solar curtain wall, it is inasethetic to adhere the junction boxes onto the glasses of the solar curtain wall or onto the periphery of the glasses. In addition, the junction boxes are relatively complex in the installation and relatively high in the cost.

### SUMMARY OF THE INVENTION

It will be advantageous to provide an electric connection system applied in solar curtain wall for electric connection among adjacent BIPV glasses in the solar curtain wall including BIPV glasses and frames.

It will be also advantageous to provide a frame with an electric connection function, which is applied on BIPV glasses.

It will be also advantageous to provide a method for using the above electric connection system.

According to the present invention, at least one technical solution of the electric connection system is provided. An electric connection system applied in solar curtain wall for electric connection among adjacent BIPV glasses in the solar curtain wall including BIPV glasses and frames. The electric connection system at least comprises:
a first electric connector connected to an electrically connecting component disposed in the BIPV glass;
a second electric connector provided in the frame and adapted for electrically mating with the first electric connector; and
a third electric connector through which the second electric connectors in the adjacent frames are electrically connected with each other.

According to one aspect of the present invention, the frame includes an accommodation portion in which the second electric connector is accommodated.

According to one aspect of the present invention, the first electric connector comprises a housing, and a plurality of first electrically connecting terminals provided in the housing; the second electric connector comprises a circuit board, a plurality of second electrically connecting terminals provided in the circuit board, and a plurality of diodes each connecting the adjacent second electrically connecting terminals; wherein the respective first electrically connecting terminal is adapted for connecting the respective electrically connecting component in the BIPV glasses with the respective second electrically connecting terminal.

Particularly, the third electric connector may be embodied as a connector for power supply, which comprises a male portion provided on the second electric connector in one frame and a female portion provided on the second electric connector in another frame adjacent to the one frame, which female portion is mated with the male portion.

According to one aspect of the present invention, the plurality of first electrically connecting terminals in the first electric connector and the electrically connecting components in the BIPV glasses are welded with each other, respectively.

Meanwhile, according to the present invention, at least one technical solution of a method for using the above electric connection system is provided. A method for using the above electric connection system, the method at least comprising the steps of:
providing first, second, and third electric connectors, and providing the solar curtain wall including BIPV glasses and frames;
accommodating the second electric connectors in the accommodation portion of each frame;
electrically connecting the plurality of first electrically connecting terminals in the first electric connector with the electrically connecting components in the BIPV glasses, respectively;
mating the second electric connector in the frame with the first electric connector in the BIPV glass when the BIPV glass is mounted onto the frame; and
electrically connecting the second electric connectors in the adjacent frames through the third electric connector.

According to one aspect of the present invention, the plurality of first electrically connecting terminals in the first electric connector and the electrically connecting components in the BIPV glasses are welded with each other, respectively.

In addition, according to the present invention, at least one technical solution of a frame with an electric connection function, which is applied on BIPV glasses is provided. A frame with an electric connection function, which is applied on BIPV glasses. The frame at least comprises:
a frame body;
a second electric connector disposed in the frame body and adapted for mating with a first electric connector in the BIPV glasses to achieve an electric connection.

Particularly, the frame comprises an accommodation portion in which the second electric connector is accommodated.

According to one aspect of the present invention, the second electric connector comprises a circuit board, a plurality of second electrically connecting terminals provided in the circuit board, and a plurality of diodes each connecting the adjacent second electrically connecting terminals; wherein the respective second electrically connecting terminal is adapted for connecting the respective first electrically connecting terminal in the first electric connector.

According to one aspect of the present invention, the second electric connectors in the adjacent frames are connected through a connector for power supply. Preferably, the frame is made by aluminum materials.

As apparent form the above, the present invention has at least the following advantages: the electric connection system according to the present invention may be safely and effectively embedded in the frames of the solar curtain wall for electric connection among adjacent BIPV glasses in the solar curtain wall. Accordingly, the junction box used in the prior art may be successfully replaced by the electric connection system according to the present invention so as to overcome the drawbacks liking destructible due to be exposed to the outside, inasethetic in the whole appearance, and relative high in cost existed in the prior junction box.

### BRIEF DESCRIPTION OF THE DRAWINGS

These and/or other aspects and advantages of the invention will become apparent and more readily appreciated from the following description of the embodiments, taken in conjunction with the accompanying drawings of which:
Fig. 1 is a structural schematic view of an electric connection system applied in solar curtain wall according to a preferred embodiment of the present invention;
Fig. 2 is a partial-enlarged structural schematic view of Fig. 1;
Fig. 3 is an enlarged structural schematic view of a first electric connector in the electric connection system according to the preferred embodiment of the present invention;
Fig. 4 is an enlarged structural schematic view of a second electric connector in the electric connection system according to the preferred embodiment of the present invention;
Fig. 5 is another enlarged structural schematic view of a second electric connector in the electric connection system according to the preferred embodiment of the present invention;
Fig. 6 is an enlarged structural schematic view of a third electric connector in the electric connection system according to the preferred embodiment of the present invention;
Fig. 7 is an exploded structural schematic view of an electric connection system applied in the solar curtain wall according to the preferred embodiment of the present invention.

### DETAILED DESCRIPTION OF PREFERRED EMBODIMENTS OF THE IVENTION

The embodiments of the present disclosure will be described hereinafter in detail with reference to the attached drawings, wherein the like reference numerals refer to the like elements. The present disclosure, however, should not be construed as being limited to the embodiment set forth herein; rather, these embodiments are provided so that the present disclosure will be thorough and complete, and will fully convey the concept of the disclosure to those skilled in the art.

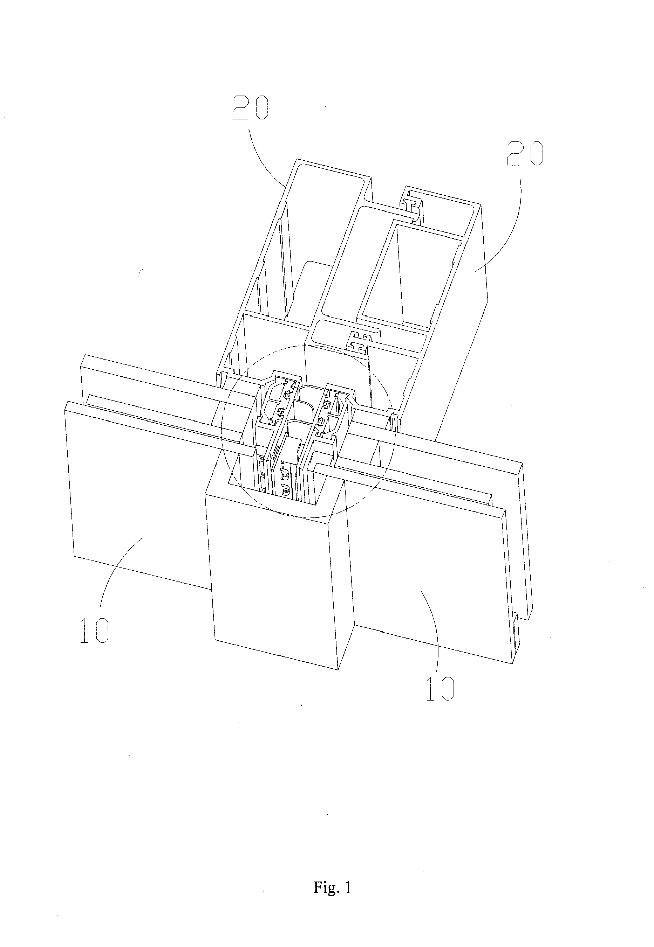

As shown in Figs. 1-2, 7, an electric connection system is provided according to one preferred embodiment of the present invention. The electric connection system is applied in a solar curtain wall for electric connection among adjacent BIPV glasses 10 in the solar curtain wall including BIPV glasses 10 and frames 20. The electric connection system at least comprises a first electric connector 30, a second electric connector 40, and a third electric connector 50. The first electric connector 30 is connected to an electrically connecting component 101 disposed in the BIPV glass 10. The second electric connector 40 is provided in the frame 20 and adapted for mating with the first electric connector 30. The second electric connectors 40 in the adjacent frames 20 are electrically connected with each other through the third electric connector 50.

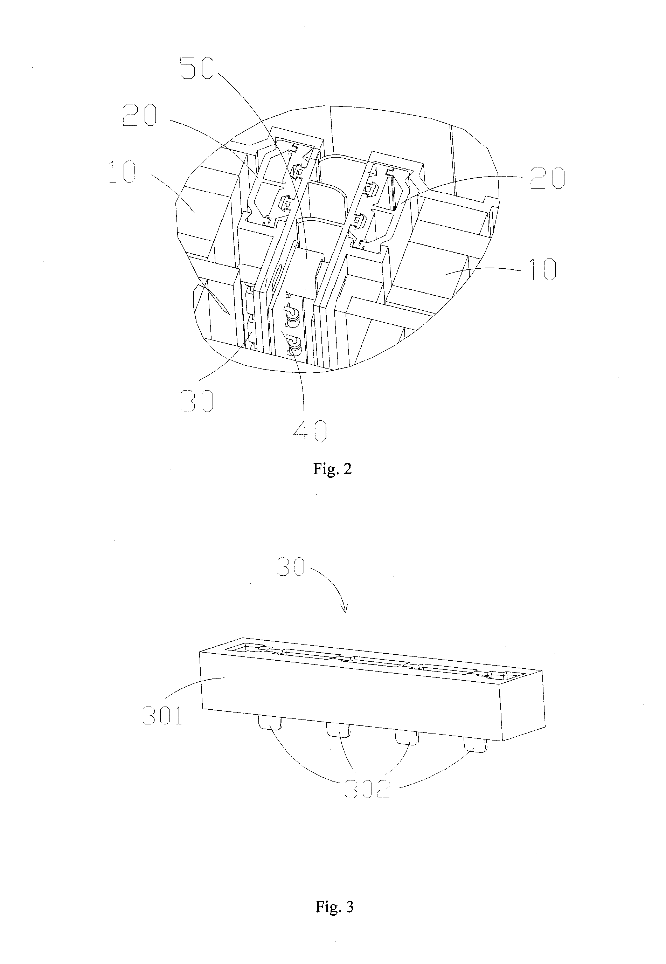

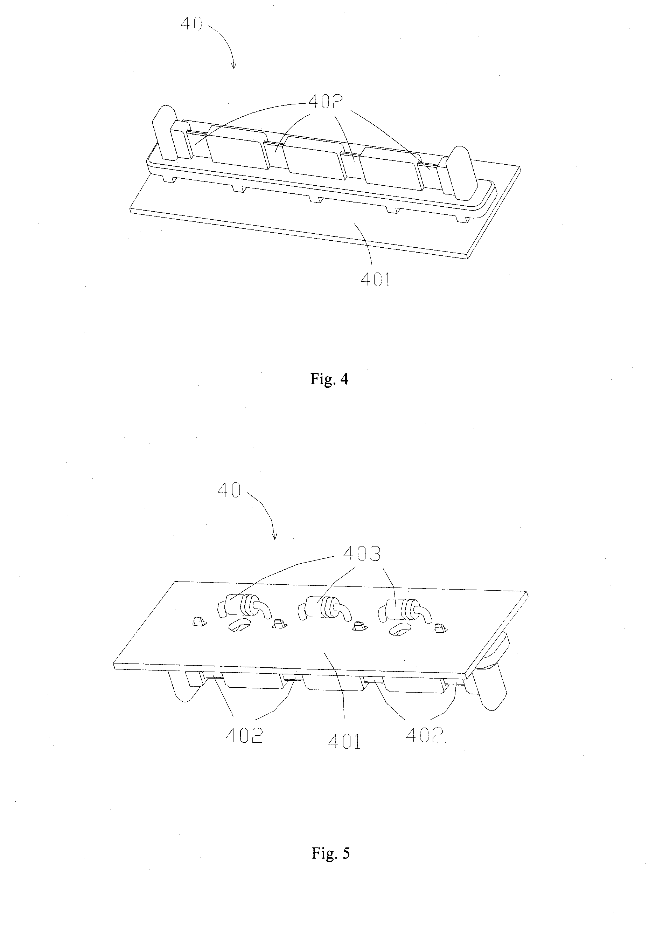

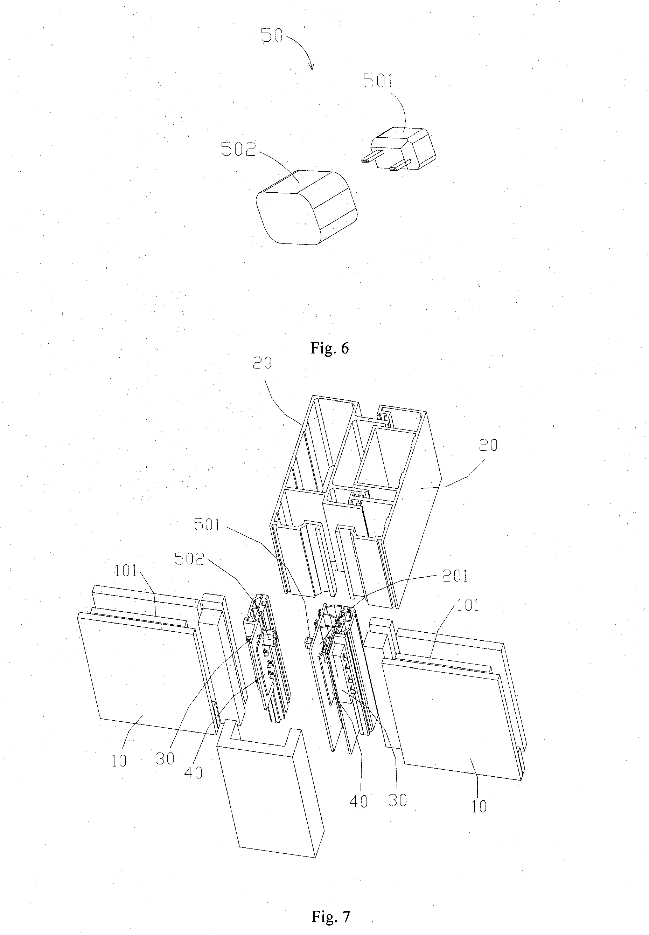

Specifically, as shown in Figs. 3-7, the first electric connector 30 comprises a housing 301 and a plurality of first electrically connecting terminals 302 provided in the housing 301, particularly in Fig. 3. The second electric connector 40 comprises a circuit board 401, a plurality of second electrically connecting terminals 402 provided in the circuit board 401, and a plurality of diodes 403 each connecting the adjacent second electrically connecting terminals 402. The respective first electrically connecting terminal 302 is adapted for connecting the respective electrically connecting component 101 in the BIPV glasses with the respective second electrically connecting terminal 402, particularly in Figs. 4 and 5. The third electric connector 50 is embodied as a connector for power supply, which comprises a male portion 501 provided on the second electric connector 40 in one frame 20 and a female portion 502 provided on the second electric connector 40 in another frame 20 adjacent to the one frame 20, which female portion 502 mates with the male portion 501, particularly in Fig. 6. In this way, electric connections among the adjacent BIPV glasses 10 are achieved by mating the first, second and third electric connector 30, 40, 50 in the electric connection system. Specifically, the frame 20 includes an accommodation portion 201 in which the second electric connector 30 is accommodated. Preferably, the plurality of first electrically connecting terminals 302 in the first electric connector 30 and the electrically connecting components 101 in the BIPV glasses 10 are welded, respectively.

Meanwhile, a method for using such electric connection system is provided according to one preferred embodiment of the present invention. Specifically, as shown in Figs. 1, 2 and 7, the method at least comprising the steps of: providing first, second, and third electric connectors 30, 40, 50, and providing the solar curtain wall including BIPV glasses 10 and frames 20; accommodating the second electric connectors 40 in the accommodation portion 201 of each frame 20; electrically connecting the plurality of first electrically connecting terminals 302 in the first electric connector 30 with the electrically connecting components 101 in the BIPV glasses 10, respectively; mating the second electric connector 40 in the frame 20 with the first electric connector 30 in the BIPV glass 10 when the BIPV glass 10 is mounted onto the frame 20; and, electrically connecting the second electric connectors 40 in the adjacent frames 20 through the third electric connector 50 for electric connection among adjacent BIPV glasses 10. In the above-mentioned method, preferably, the plurality of first electrically connecting terminals 302 in the first electric connector 30 and the electrically connecting components 101 in the BIPV glasses 10 are welded with each other, respectively. The electrically connecting component 101 is preferably a metal sheet with good electrically conducting characteristics.

In addition, as shown in Figs. 1-7, a frame 20 with an electric connection performance is provided, which is applied on BIPV glasses 10, according to one preferred embodiment of the present invention. Specifically, the frame at least comprises a frame body 20 and a second electric connector 40. The second electric connector 40 is disposed in the frame body 20 and is adapted for mating with a first electric connector 30 in the BIPV glasses 10 to achieve an electric connection. The frame 20 further comprises an accommodation portion 201 in which the second electric connector 40 is accommodated. The second electric connector 40 disposed in the frame 20 comprises a circuit board 401, a plurality of second electrically connecting terminals 402 provided in the circuit board 401, and a plurality of diodes 403 each connecting the adjacent second electrically connecting terminals 402. The respective second electrically connecting terminal 402 is adapted for connecting the respective first electrically connecting terminal 302 in the first electric connector 30, so as to achieve the electrical connection. It is worthy to mention that the first electric connector 30 may be temporarily connected to the second electric connector 40 in the frame 20 while the second electric connectors 40 on the adjacent frames 20 are connected through the connector 50 for power supply during the installation of the BIPV glasses 10 onto the frame 20. Preferably, the frame 20 is made by aluminum materials.

Although several exemplary embodiments have been shown and described, it would be appreciated by those skilled in the art that various changes or modifications may be made in these embodiments without departing from the principles and spirit of the disclosure, the scope of which is defined in the claims and their equivalents. It will be understood that, the terms "'comprises", "comprising,", "includes" and/or "including", when used herein, specify the presence of stated features, steps, and/or components, but do not preclude the presence or addition of one or more other features, steps, and/or components. Further, the singular forms "a", "an" and "the" are intended to include the plural forms as well, unless the context clearly indicates otherwise. In addition, the reference numbers used in the claims are for the purpose of describing particular embodiments only and are not intended to be limiting of example embodiments of the invention.

## Claims

1. An electric connection system applied in a solar curtain wall for electric connection among adjacent BIPV glasses (10) in the solar curtain wall including BIPV glasses (10) and frames (20), said electric connection system at least comprising:
a first electric connector (30) connected to an electrically connecting component (101) disposed in the BIPV glass (10);
a second electric connector (40) provided in the frame (20) and adapted for mating with the first electric connector (30); and
a third electric connector (50) through which the second electric connectors (40) in the adjacent frames (20) are electrically connected with each other.

2. The electric connection system according to claim 1, wherein:
the frame (20) includes an accommodation portion (201) in which the second electric connector is accommodated.

3. The electric connection system according to claim 1, wherein:
the first electric connector (30) comprises a housing (301), and a plurality of first electrically connecting terminals (302) provided in the housing (301); the second electric connector (40) comprises a circuit board (401), a plurality of second electrically connecting terminals (402) provided in the circuit board (401), and a plurality of diodes (403) each connecting the adjacent second electrically connecting terminals (402);
wherein the respective first electrically connecting terminal (302) is adapted for connecting the respective electrically connecting component (101) in the BIPV glasses with the respective second electrically connecting terminal (402).

4. The electric connection system according to claim 3, wherein:
the third electric connector (50) is embodied as a connector for power supply, which comprises a male portion (501) provided on the second electric connector (40) in one frame (20) and a female portion (502) provided on the second electric connector (40) in another frame (20) adjacent to the one frame (20) and adapted to mate with the male portion (501).

5. The electric connection system according to claim 3, wherein:
the plurality of first electrically connecting terminals (302) in the first electric connector (30) and the electrically connecting components (101) in the BIPV glasses (10) are welded with each other, respectively.

6. A method for using such electric connection system according to any one of claims 1-5, the method at least comprising the steps of:
providing first, second, and third electric connectors, and providing the solar curtain wall including BIPV glasses and frames;
accommodating the second electric connectors in the accommodation portion of each frame;
electrically connecting the plurality of first electrically connecting terminals in the first electric connector with the electrically connecting components in the BIPV glasses, respectively;
mating the second electric connector in the frame with the first electric connector in the BIPV glass when the BIPV glass is mounted onto the frame; and
electrically connecting the second electric connectors in the adjacent frames through the third electric connector.

7. The method according to claim 6, wherein:
the plurality of first electrically connecting terminals in the first electric connector and the electrically connecting components in the BIPV glasses are welded with each other, respectively.

8. A frame with an electric connection function, which is applied on BIPV glasses (10), the frame comprises:
a frame body (20);
a second electric connector (40) disposed in the frame body (20) and adapted for mating with a first electric connector (30) in the BIPV glasses (10) to achieve an electric connection.

9. The frame according to claim 8, further comprising:
an accommodation portion (201) in which the second electric connector (40) is accommodated.

10. The frame according to claim 8, wherein:
the second electric connector (40) comprises a circuit board (401), a plurality of second electrically connecting terminals (402) provided in the circuit board (401), and a plurality of diodes (403) each connecting the adjacent second electrically connecting terminals (402);
wherein the respective second electrically connecting terminal (402) is adapted for connecting the respective first electrically connecting terminal (302) in the first electric connector (30).

11. The frame according to claim 8, wherein:
the second electric connectors (40) in the adjacent frames are connected through a connector (50) for power supply.

12. The frame according to claim 8, wherein the frame is made by aluminum materials.
